(19) Europäisches Patentamt
European Patent Office
Office européen des brevets

(11) EP 1 085 626 A1

(12) **EUROPEAN PATENT APPLICATION**
published in accordance with Art. 158(3) EPC

(43) Date of publication:
**21.03.2001 Bulletin 2001/12**

(21) Application number: **00903967.8**

(22) Date of filing: **16.02.2000**

(51) Int. Cl.$^7$: **H01S 5/20**

(86) International application number:
**PCT/JP00/00852**

(87) International publication number:
**WO 00/49694 (24.08.2000 Gazette 2000/34)**

(84) Designated Contracting States:
**CH DE FR GB IT LI**

(30) Priority: **16.02.1999 JP 3674699**

(71) Applicant:
**The Furukawa Electric Co., Ltd.**
**Tokyo 100-8322 (JP)**

(72) Inventors:
- **YAMAGUCHI, Takeharu,**
  **The Furukawa Electric Co.,**
  **Chiyoda-ku, Tokyo 100 -8322 (JP)**
- **MUKAIHARA, Toshikazu,**
  **The Furukawa Electric Co.,**
  **Chiyoda-ku, Tokyo 100 -8322 (JP)**
- **KASUKAWA, Akihiko,**
  **The Furukawa Electric Co.,**
  **Chiyoda-ku, Tokyo 100 -8322 (JP)**

(74) Representative:
**Pätzold, Herbert, Dr.-Ing. et al**
**Steubstrasse 10**
**82166 Gräfelfing (DE)**

# (54) SEMICONDUCTOR LASER

(57) A semiconductor laser (200) comprises a semiconductor substrate (100), a pair of cladding layers (110, 150) formed on the substrate, a pair of undoped SCH layers (120, 140) disposed between the cladding layers (110, 150), and an active quantum well layer (130) disposed between the undoped SCH layers (120, 140). The waveguide loss of light output in leaky mode is smaller than the mode gain of the semiconductor laser because the existence of the SCH layers (120, 140) and the adequate film thickness of the cladding layers (110, 150). The laser provides low threshold current and high emission efficiency.

Fig. 1

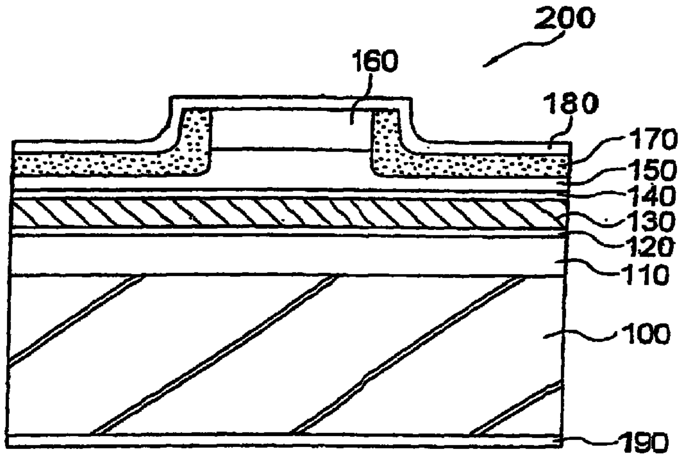


EP 1 085 626 A1

## Description

### FIELD OF THE INVENTION

The present invention relates to a semiconductor light emitting device and, more particularly, to a semiconductor light emitting device, such as semiconductor laser, suitable for use in an optical communication system as an optical amplifier having a low waveguide loss.

### BACKGROUND

Semiconductor lasers made of InGaAs based compound semiconductors (referred to as InGaAs based semiconductor lasers) and having a wavelength of 980 nm range are widely used as a variety of light sources, such as a pumping light source in an optical fiber amplifier. Fig. 3 shows a conventional InGaAs based semiconductor laser having a 980-nm-range wavelength in a cross-section.

The conventional semiconductor laser, as shown in Fig. 3, generally designated by numeral 10, includes a 100-μm-thick n-type GaAs (n-GaAs) substrate 1, and epitaxial layers consecutively grown thereon. The epitaxial layers includes, consecutively from the substrate 1, a 1.7-μm-thick n-AlGaAs cladding layer 2, a 30-nm-thick undoped AlGaAs SCH layer 3, InGaAs/GaAs quantum well 4, a 30-nm-thick undoped AlGaAs SCH layer 5, a 1.7-μm-thick p-AlGaAs cladding layer 6, and a 0.3-μ-thick p-GaAs cap layer 7.

The cap layer 7 and the top portion of the cladding layer 6 are configured as a 4-μm-wide mesa stripe. A passivation layer 8 made of SiN is formed on the area other than the top surface of the cap layer 7. A p-side electrode 9 made of Ti/Pt/Au metallic layers is formed on the top of the passivation layer and an n-side electrode 10 made of AuGe/Ni/Au metallic layers are formed on the bottom surface of the substrate 1.

The conventional InGaAs based semiconductor laser device 20 has a bandgap energy Eg1 of 1.41 eV at the n-GaAs substrate 1, and a bandgap energy Eg2 of 1.27 eV at the active layers 4, wherein Eg1>Eg2. Thus, the light having a bandgap energy Eg2 can pass through the n-GaAs substrate.

Fig. 4 shows the semiconductor laser device 20 of Fig. 3 at a fabrication step thereof. For fabrication of the semiconductor laser device 20, first, a 1.7-μm-thick n-AlGaAs cladding layer 2, a 30-nm-thick undoped AlGaAs SCH layer 3, InGaAs/GaAs quantum well active layers 4, a 30-nm-thick undoped AlGaAs SCH layer 5, a 1.7-μm-thick p-AlGaAs cladding layer 6, and a 0.3-μ-thick p-GaAs cap layer 7 are consecutively grown on a n-GaAs substrate 1 by a metal-organic chemical vapor deposition (MOCVD) technique.

Subsequently, the cap layer 7 and the top portion of the cladding layer 6 are etched to form a 4-μm-wide mesa stripe, followed by deposition of a passivation layer 8 made of SiN on the cap layer 7. Thereafter, a portion of the passivation layer 8 on the top of the mesa stripe is etched to form an opening for injection of current.

Further, the bottom of the n-GaAs substrate 1 is polished to obtain a total thickness of 100 μm for the substrate 1, followed by evaporation of metals on the passivation layer 8 and the bottom of the substrate 1, to form the p-side Ti/Pt/Au electrode 9 and the n-side AuGe/Ni/Au electrode 10. Thus, the InGaAs based semiconductor laser 20 of Fig. 3 can be achieved.

The conventional InGaAs based semiconductor laser has a disadvantage in that the semiconductor laser has a large waveguide loss, which causes a larger threshold current for lasing and thus a lower lasing efficiency. The large wave guide loss was confirmed by fabricating the semiconductor laser of Fig. 3 and another semiconductor laser having a structure similar to the semiconductor laser of Fig. 3 except for the active layers, which were made of GaAs/AlGaAs based compound semiconductors and lasing at a wavelength of 850-nm range in the another semiconductor laser. The another semiconductor laser had a waveguide loss lower than the waveguide loss of the conventional InGaAs based semiconductor laser by several units in terms of $cm^{-1}$.

### SUMMARY OF THE INVENTION

It is therefore an object of the present invention to provide an InGaAs based semiconductor laser having a lower threshold current for lasing and thus a higher lasing efficiency.

The present invention provides an InGaAs based semiconductor laser including a semiconductor substrate having a first conductivity-type, and a first cladding layer having the first conductivity-type, an active layer structure for lasing at a first wavelength, a second cladding layer having a second conductivity-type opposite to the first conductivity-type, and a cap layer having the second conductivity-type, which are consecutively formed on the semiconductor substrate, the first wavelength being larger than a bandgap wavelength of the semiconductor substrate, an effective refractive index of a light emitting waveguide mode being lower than a refractive index of the semiconductor substrate, characterized in that a waveguide loss generated by leakage of light power from the first cladding layer to the semiconductor substrate and from the second cladding layer to the cap layer in a leaky mode is lower than a modal gain of the semiconductor light emitting device.

In accordance with the InGaAs based semiconductor light emitting device of the present invention, the lower waveguide loss generated by the leaky mode of light power compared to the modal gain of the semiconductor light emitting device provides a lower threshold current for light emission and thus a higher emission efficiency of the semiconductor light emitting device.

The present invention can be applied to both a facet emission semiconductor laser and a surface emission semiconductor laser so long as the raltionship between the effective refractive index ($n_{eff}$) of the lasing waveguide mode and the refractive index ($n_{sub}$) of the substrate is $n_{eff}<n_{sub}$. The present invention is also applicable to any of GaAs, InGaAs, InGaNAs and InP based light emitting devices irrespective of the compositions of the semiconductor substrates and the active layers.

In a preferred embodiment, the waveguide loss generated by the leaky mode of the light power at the lasing wavelength is below 3 $cm^{-1}$. This is achieved by the configuration wherein the overall confinement coefficient of waveguide layers including the first-conductivity-type cladding layer, the active layer and the second-conductivity-type cladding layer is 90% or more. If the lasing wavelength is 980-nm range, a pair of SCH layers acting as a part of active layers may be provided for sandwiching therebetween the active layer structure. In addition, the thickness of the first and the second cladding layers may be 2 μm or more. The active layer structure may include a quantum well structure and a pair of SCH (Separate Confinement Hetero-structure) layers sandwiching therebetween the quantum well structure. The quantum well structure may include indium or nitride.

If each of the cladding layers is made of $Al_xGa_{1-x}As$, and each of the SCH layers is made of $Al_yGa_{1-y}As$, the following relationships should hold:

$$0<x\leqq 1,\ 0\leqq y<1 \text{ and } x>y.$$

Therefore, if we choose suitable values for x and y satisfying the above relationships, we can control two confinement coefficients independently of each other, which are used for the quantum well layer and for the active layers including SCH layer and two cladding layers.

BRIEF DESCRIPTION OF THE DRAWINGS

Fig. 1 is a cross-sectional view of an InGaAs based semiconductor laser according to an embodiment of the present invention.

Fig. 2 is a graph for showing relationship between injected current and an optical output of the semiconductor laser of Fig. 1.

Fig. 3 is a cross-sectional view of a conventional InGaAs based semiconductor laser.

Fig. 4 is a cross-sectional view of the InGaAs based semiconductor laser of Fig. 3 at a fabrication step thereof.

Fig. 5 is a graph for showing relationship between injected current and an optical output of the semiconductor laser of Fig. 4.

PREFERRED EMBODIMENTS

Before describing preferred embodiment of the present invention, the disadvantage of the conventional InGaAs based semiconductor laser will be discussed for a better understanding of the present invention.

It is known that the causes of the waveguide loss studied heretofore include the optical absorption by the substrate. This is considered to result from the fact that if the substrate is opaque against the lasing wavelength of the semiconductor light emitting device, the light emitting mode is subjected to the optical absorption by the substrate to have a waveguide loss when the optical electric field in the light emitting mode reaches the substrate.

Since the GaAs substrate is opaque against the lasing wavelength of the GaAs/AlGaAs based semiconductor laser, according to the conventional theory for the optical absorption, the light emitting mode is subjected to the light absorption by the substrate to have a waveguide loss when the optical electric field in the light emitting mode reaches the GaAs substrate. On the other hand, since the GaAs substrate is transparent for the lasing wavelength of the InGaAs based semiconductor laser, it is considered that the light emitting mode is not affected by the light absorption from the substrate and the waveguide loss is not increased even if the optical electric field of the light emitting mode reaches the GaAs substrate.

However, according to our experiments for the waveguide loss, it was confirmed, contrary to the study based on the conventional theory for the optical absorption by the substrate, that the waveguide loss of the InGaAs based semiconductor laser was higher than the waveguide loss of the GaAs/AlGaAs based semiconductor laser, which implies that there is unknown cause for the waveguide loss other than the optical absorption by the substrate.

The inventors thus analyzed the waveguide loss to finally find a cause of the waveguide loss, which originates from the fact that the waveguide loss caused by the leaky mode is higher compared to the modal gain of the light emitting device. The term "leaky mode" as used herein may be also referred to as substrate radiation mode, and means a mode generated when the conditions for total reflection of light power are not satisfied in the waveguide.

The modal gain $g_{max}$ means a gain for a lasing mode and expressed by:

$$\Gamma \times g_{max}=\alpha_i+(1/2L)\times\ln(1/R_fR_r)$$

wherein $\alpha_i$, L, $R_f$, $R_r$, and $\Gamma$ represent loss factor, length of the resonator, square of reflectance for the electric field at the front facet of the laser, square of the reflectance for the electric field at the rear facet of the laser, and the light confinement factor of the lasing mode, respectively.

It was finally found after experiments that a semiconductor light emitting device having a lower wave guide loss can be achieved by sandwiching a quantum well active layer structure between a pair of SCH layers while in contact therewith, increasing the thickness of the first and second cladding layers compared to the conventional device to decrease the leaky mode waveguide loss down to 3 $cm^{-1}$ or less at the lasing wavelength.

It is sufficient in fact that the leaky mode waveguide loss be below the waveguide loss generated by other causes in order to obtain the reduction of the threshold current for the lasing, although the leaky mode waveguide loss being less below 3 $cm^{-1}$ was found in the experiments.

The waveguide loss was examined in relation to the compositions of the cladding layers and the SCH layers. It was found that the leaky mode equal to or below 3 $cm^{-1}$ can be obtained by maintaining the light confinement factor of the waveguide layers including the SCH layers and the cladding layers at 90% or above.

The light power distribution P in the direction y perpendicular to the surface of the substrate is expressed by a Gaussian beam formula:

$$P=P_0 * \exp(-2(y/W)^2)$$

wherein W is a half width of a range within which the light power assumes more than $e^{-2}$ of the peak thereof, and $P_0$ is a constant.

In order for maintaining 90% or above for the overall light confinement coefficient of waveguide layers including the quantum well active layers, the SCH layers and the cladding layers, the half width W, the thickness $T_s$ of the SCH layers, the thickness $T_{clad}$ of the cladding layer and the thickness $T_{act}$ of the quantum active layers should satisfy the following relationship:

$$T_{act}/2+T_{sch}+T_{clad} \geqq 2.3\ W.$$

In the above relationship, the constant 2.3 in the right side is determined for "k" so that the ratio of the integrate of the light power distribution P from -∞ to +∞ to the integrate of P from -kW to +kW. with respect to y assumes 0.9 (corresponding to 90% of the overall light confinement coefficient).

The half width W can be obtained by measuring the far field pattern (FFP) of the light beam from the following expression:

$$W=(\lambda/\pi)/\tan\theta$$

wherein λ is the lasing wavelength and θ is a half width of the angle range within which the light power assumes above $e^{-2}$ of the peak thereof when the FFP characteristics are depicted by a graph showing the light power plotted against the radiation angle.

In the above description, a facet emission semiconductor laser is exemplified. However, the present invention can be applied to a plane emission semiconductor laser, irrespective of the output wavelength of the semiconductor laser.

Now, the present invention is more specifically described with reference to an embodiment of the present invention.

Referring to Fig. 1, a semiconductor light emitting device according to the embodiment of the present invention is implemented by an InGaAs based semiconductor laser of a facet emission type lasing at a wavelength of 980-nm range.

The semiconductor laser, generally designated by numeral 200, includes a 100-μm-thick n-GaAs substrate 100, and epitaxial layers consecutively formed on the n-GaAs substrate 100. The epitaxial layers include, consecutively from the n-GaAs substrate 100, a 2-μm-thick n-$Al_{0.3}Ga_{0.7}As$ cladding layer 110, a 30-nm-thick undoped $Al_{0.2}Ga_{0.8}As$ SCH layer 120, a quantum well structure 130 including a pair of undoped InGaAs/GaAs layers, a 30-nm-thick undoped $Al_{0.2}Ga_{0.8}As$ SCH layer 140, a 2-μm-thick p-$Al_{0.3}Ga_{0.7}As$ cladding layer 150 and a 0.3-μm-thick GaAs cap layer 160. The quantum well structure 130 and the pair of SCH layers 140 and 150 may be referred to as active layers. A single or plurality of pairs each including a quantum well layer and a barrier layer may be provided in the quantum well structure.

The cap layer 160 and the top portion of the cladding layer 150 are configured as a 4-μm-wide mesa stripe, and a passivation layer 170 made of SiN is formed on the side surfaces of the mesa stripe and the exposed surface of the cladding layer 150. A p-side electrode 180 made of Ti/Pt/Au layered metallic films and an n-side electrode 190 made of AuGe/Ni/Au layered metallic films are formed on the passivation layer 170 and on the bottom surface of the n-GaAs substrate 100, respectively.

In the present embodiment, the refractive index $n_{sub}$ of the substrate 100 is 3.46 at the lasing wavelength, whereas the effective refractive index $n_{eff}$ of the lasing waveguide mode is 3.35. In addition, the overall light confinement coefficient of the waveguide layers including the cladding layer 110, the active layers 130, and the cladding layer 150 is 99%, namely, above 90%. Further, the thickness of both the cladding layers 110 and 150 is 2 μm which is larger compared to the thickness 1.7 μm of the cladding layers in the conventional device.

In a practical sample of the semiconductor light emitting device experimentally fabricated for the present embodiment, the waveguide loss generated by the leaky mode was measured at below 3 $cm^{-1}$. Fig. 3 shows the optical output of the sample measured against the injected current.

In Fig. 3, the threshold current of the sample is reduced to 30 mA compared to the threshold current of 35 mA for the conventional device including cladding layers having a thickness of 1.7 µm. In addition, the quantum efficiency was improved by 20%. The calculation of the waveguide loss in the sample and the conventional devices revealed that the conventional device including 1.7-µm-thick cladding layers involves a waveguide loss larger than 3 $cm^{-1}$, whereas the waveguide loss of the sample having 2- µm-thick cladding layers is below 3 $cm^{-1}$. In short, the semiconductor emitting device of the present invention has a lower threshold current and a higher light emitting efficiency by lowering the waveguide loss.

Since the above embodiments are described only for examples, the present invention is not limited to the above embodiments and various modifications or alterations can be easily made therefrom by those skilled in the art without departing from the scope of the present invention.

**Claims**

1. A semiconductor light emitting device comprising a semiconductor substrate having a first conductivity-type, and a first cladding layer having said first conductivity-type, an active layer structure for lasing at a first wavelength, a second cladding layer having a second conductivity-type opposite to said first conductivity-type, and a cap layer having said second conductivity-type, which are consecutively formed on said semiconductor substrate, the first wavelength being larger than a baudgap wavelength of said semiconductor substrate, an effective refractive index of a light emitting waveguide mode being lower than a refractive index of said semiconductor substrate, characterized in that:

   a waveguide loss generated by leakage of light power from said first cladding layer to said semiconductor substrate and from said second cladding layer to said cap layer in a leaky mode is lower than a modal gain of said semiconductor light emitting device.

2. The semiconductor light emitting device as defined in claim 1, wherein the waveguide loss generated in the leaky mode is 3 $cm^{-1}$ or less.

3. The semiconductor light emitting device as defined in claim 1 or 2, wherein an overall light confinement coefficient of layers including said first and second cladding layers and said active layers is 90% or more.

4. The semiconductor light emitting device as defined in one of claims 1 to 3, wherein said semiconductor substrate is made of GaAs, and said active structure is made of a compound semiconductor including at least one of indium (In) and nitrogen (N).

5. The semiconductor light emitting device as defined in claim 1, wherein said active layer structure includes a quantum well structure and a pair of separate confinement hetero-structure (SCH) layers sandwiching therebetween said quantum well structure.

6. The semiconductor light emitting device as defined in claim 5, wherein the following relationship holds:

   $$T_{act}/2+T_{sch}+T_{clad} \geqq 2.3W$$

   wherein W, $T_{act}$, $T_{sch}$ and $T_{clad}$ are a half width of a lasing mode of said quantum well layers in a direction perpendicular to said layers, a thickness of said quantum well structure, a thickness of one of said SCH layers, and a thickness of one of said cladding layers disposed in contact with said one of said SCH layers.

7. The semiconductor light emitting device as defined in claim 5 or 6, wherein said first wavelength resides in a 980-nm range and each of said first and second cladding layers has a thickness equal to or larger than 2 µm.

8. The semiconductor light emitting device as defined in one of claims 5 to 7, wherein each of said cladding layers is made of $Al_xGa_{1-x}As$, each of said SCH layers is made of $Al_yGa_{1-y}As$, and the following relationships hold:

   $$0<x \leqq 1,\ 0 \leqq y<1 \text{ and } x>y.$$

Fig. 1

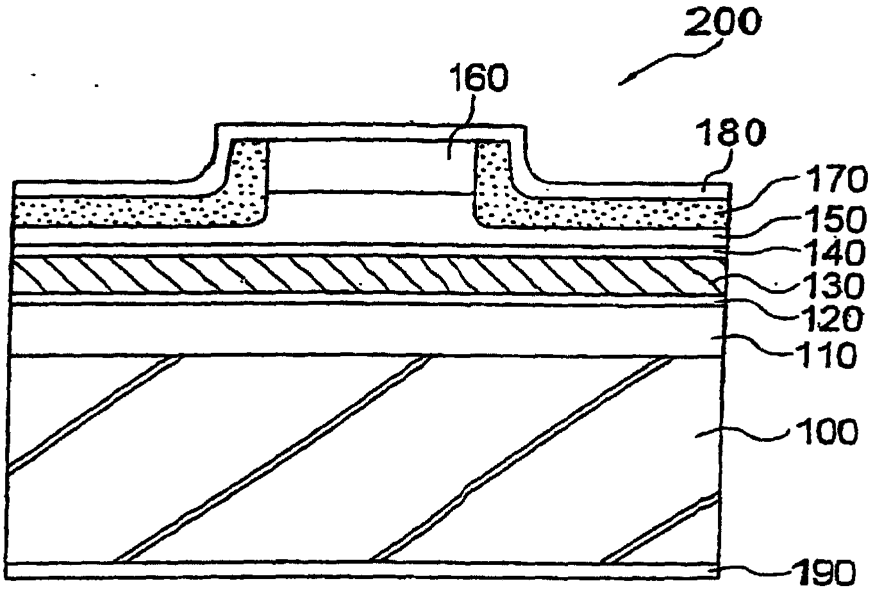

Fig. 2

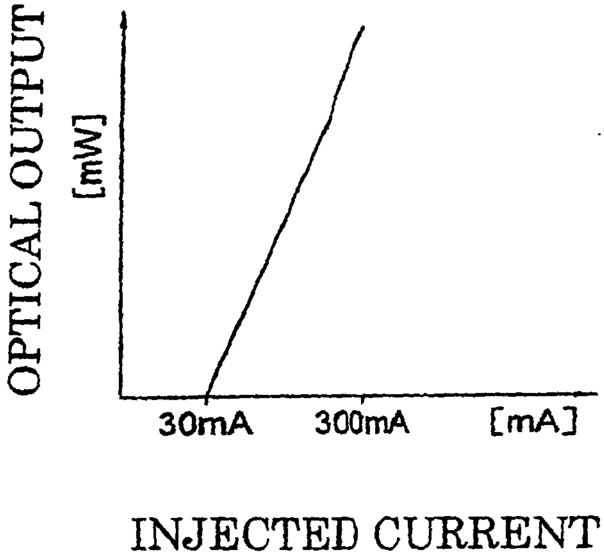

Fig. 3

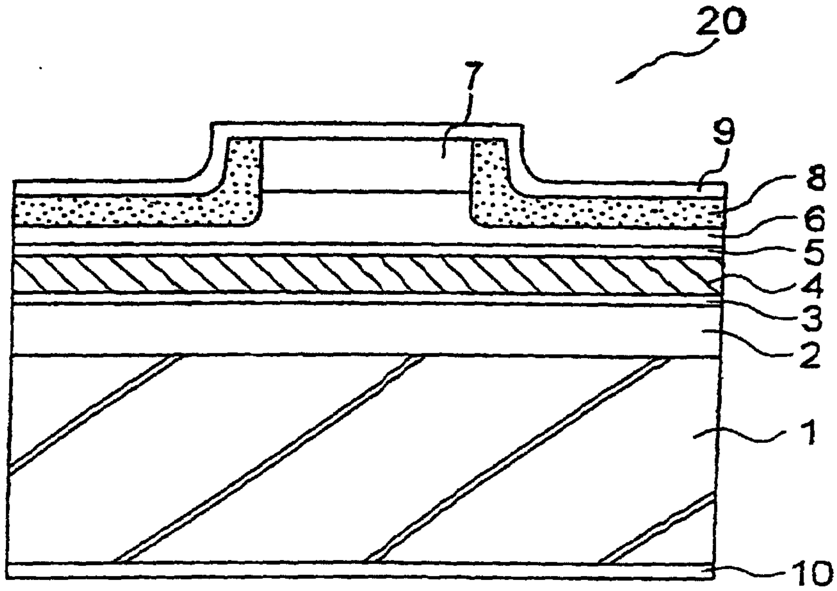

Fig. 4

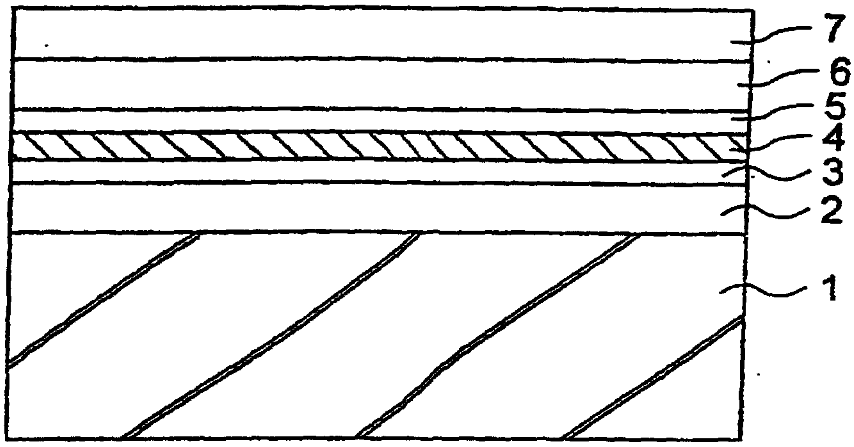


Fig. 5

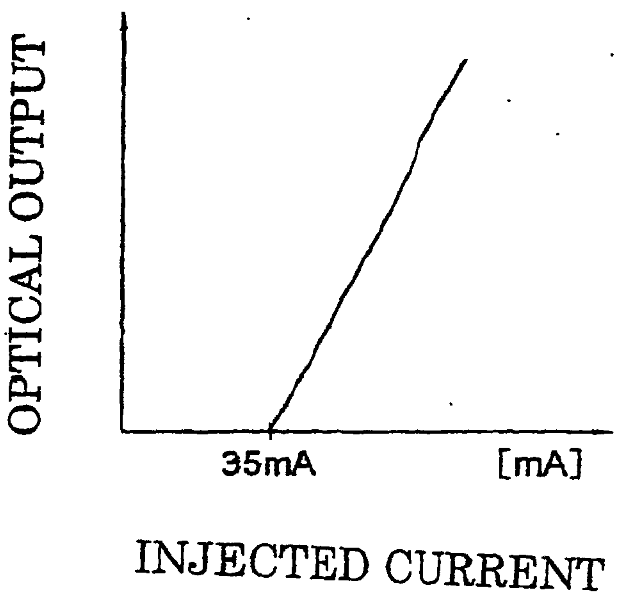

**INTERNATIONAL SEARCH REPORT**

International application No. PCT/JP00/00852

A. CLASSIFICATION OF SUBJECT MATTER
Int.Cl[7] H01S 5/20

According to International Patent Classification (IPC) or to both national classification and IPC

B. FIELDS SEARCHED

Minimum documentation searched (classification system followed by classification symbols)
Int.Cl[7] H01S 5/00-5/50

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2000 |
| Kokai Jitsuyo Shinan Koho | 1971-2000 | Jitsuyo Shinan Toroku Koho | 1996-2000 |

Electronic data base consulted during the international search (name of data base and, where practicable, search terms used)
JICST FILE(JOIS)

C. DOCUMENTS CONSIDERED TO BE RELEVANT

| Category* | Citation of document, with indication, where appropriate, of the relevant passages | Relevant to claim No. |
|---|---|---|
| X | JP, 9-307184, A (The Furukawa Electric Co., Ltd.), 28 November, 1997 (28.11.97), Full text; all drawings (Family: none) | 1-8 |
| A | JP, 7-235728, A (Fujitsu Limited), 05 September, 1995 (05.09.95), Full text; all drawings (Family: none) | 1-8 |
| A | US, 5818860, A (David Sarnoff Research Center,Inc.), 06 October, 1998 (06.10.98), Full text; all drawings & JP, 10-303500, A | 1-8 |
| A | TOSHIKAI FUKUNAGA ET.AL., Highly Reliable Operation of High-Power InGaAsP/AnGaP/AlGaAs 0.8μm Separate Confinement Heterostructure Laser, Japanese Journal of Applied Physics Part 2,1995,Vol.34,No.9B,L.1175-1177 | 1-8 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 01 May, 2000 (01.05.00) | 16.05.00 |
| Name and mailing address of the ISA/ Japanese Patent Office | Authorized officer |
| Facsimile No. | Telephone No. |

Form PCT/ISA/210 (second sheet) (July 1992)